# EUROPEAN PATENT APPLICATION

(11) **EP 1 679 788 A1**
(43) Date of publication of application: **12.07.2006**
(21) Application number: 03770040.8
(22) Date of filing: 30.10.2003
(51) Int. Cl.: H03C 3/00, H03D 7/02

(54) **PULSE MODULATION CIRCUIT**

(71) Applicant: MITSUBISHI DENKI KABUSHIKI KAISHA, Chiyoda-ku, Tokyo 100-8310 (JP)
(72) Inventor: KAWAKAMI, Kenji, MITSUBISHI DENKI KABUSHIKI KAISHA, Chiyoda-ku, Tokyo 100-8310 (JP); HAMANO, Satoshi, MITSUBISHI DENKI KABUSHIKI KAISHA, Chiyoda-ku, Tokyo 100-8310 (JP); UEHARA, Naohisa, MITSUBISHI DENKI KABUSHIKI KAISHA, Chiyoda-ku, Tokyo 100-8310 (JP); ONO, Masayoshi, MITSUBISHI DENKI KABUSHIKI KAISHA, Chiyoda-ku, Tokyo 100-8310 (JP); TSURU, Masaomi, MITSUBISHI DENKI KABUSHIKI KAISHA, Chiyoda-ku, Tokyo 100-8310 (JP)
(74) Representative: Pfenning, Meinig & Partner GbR
(86) International application number: PCT/JP2003/013947
(87) International publication number: WO 2005/043744

(57) **Abstract**

A resistor 8 for dividing a voltage applied to an anti-parallel diode pair 5 for mixing a DC pulsed signal and a local oscillation signal LO is disposed in pulse modulation circuitry. Therefore, the ratio of the output power of an RF pulsed signal outputted to an RF pulse output terminal 7 at the time of the ON state and the output power at the time of the OFF state can be increased.

## Description

### Field of the Invention

The present invention relates to pulse modulation circuitry which modulates the frequency of a pulsed signal.

### Background of the Invention

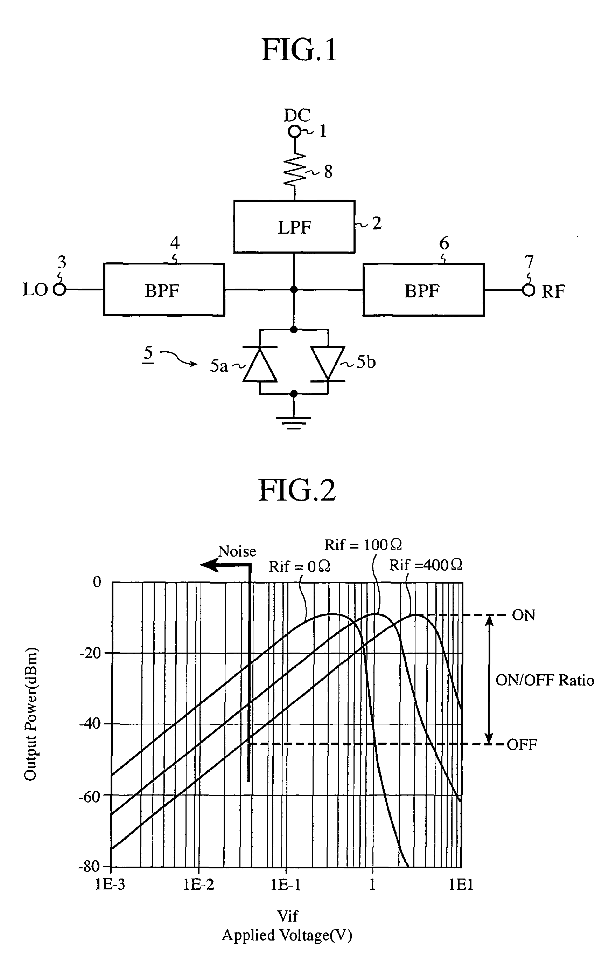

When related art pulse modulation circuitry receives a pulsed signal from a pulse applying terminal and also receives a local oscillation signal LO from a local oscillation wave input terminal, an anti-parallel diode pair included in the related art pulse modulation circuitry mixes the pulsed signal and local oscillation signal LO, and outputs a pulsed signal having a frequency twice the frequency of the local oscillation signal LO to an RF terminal (refer to the following patent reference 1).
[Patent reference 1] JP, 2000-338233,A (see pages 6 to 7 and Fig. 1)

While the related art pulse modulation circuitry constructed as mentioned above can output a pulsed signal having a frequency twice the frequency of the local oscillation signal LO to the RF terminal, a problem with the related art pulse modulation circuitry is, however, that since noise of tens of mV is superimposed onto the pulsed signal applied to the pulse applying terminal when the pulsed signal has a voltage close to zero bolts, it is necessary to set the output power of the pulsed signal outputted to the RF terminal at a time when it is put in the OFF state to higher one in order to avoid the influence of the noise, and therefore the ratio of the output power of the pulsed signal outputted to the RF terminal at the time of the ON state and the output power at the time of the OFF state becomes small.

The present invention is made in order to solve the above-mentioned problem, and it is therefore an object of the present invention to provide pulse modulation circuitry which can increase the ratio of the output power of a pulsed signal outputted to an RF terminal at the time of the ON state and the output power at the time of the OFF state.

### Disclosure of the Invention

Pulse modulation circuitry in accordance with the present invention includes a voltage dividing means for dividing a voltage applied to a mixing means for mixing a pulsed signal delivered thereto from a branching means, and a local oscillation signal. Therefore, the ratio of the output power of a pulsed signal outputted to a pulse output terminal at the time of the ON state and the output power at the time of the OFF state can be increased.

### Brief Description of the Figures

Fig. 1 is a block diagram showing pulse modulation circuitry in accordance with embodiment 1 of the present invention;
Fig. 2 is a graphical representation showing a relationship between an applied voltage of a DC pulsed signal, and the output power of an RF pulsed signal;
Fig. 3 is a diagram showing the equivalent circuit of an anti-parallel diode pair;
Fig. 4 is a graphical representation showing the phase of a second harmonic;
Fig. 5 is a block diagram showing pulse modulation circuitry in accordance with embodiment 2 of the present invention;
Fig. 6 is a block diagram showing pulse modulation circuitry in accordance with embodiment 3 of the present invention;
Fig. 7 is a block diagram showing pulse modulation circuitry in accordance with embodiment 4 of the present invention;
Fig. 8 is a block diagram showing pulse modulation circuitry in accordance with embodiment 5 of the present invention;
Fig. 9 is a graphical representation showing characteristics in a case where a diode is connected in series;
Fig. 10 is a block diagram showing pulse modulation circuitry in accordance with embodiment 6 of the present invention;
Fig. 11 is a block diagram showing pulse modulation circuitry in accordance with embodiment 7 of the present invention;
Fig. 12 is a block diagram showing pulse modulation circuitry in accordance with embodiment 7 of the present invention; and
Fig. 13 is a block diagram showing pulse modulation circuitry in accordance with embodiment 8 of the present invention.

### Preferred Embodiments of the Invention

Hereafter, in order to explain this invention in greater detail, the preferred embodiments of the present invention will be described with reference to the accompanying drawings. Embodiment 1.

Fig. 1 is a block diagram showing pulse modulation circuitry in accordance with embodiment 1 of the present invention. In the figure, a low pass filter (referred to as an LPF from here on) 2 receives a DC pulsed signal (a pulsed signal) applied to a DC pulse applying terminal 1, removes an unnecessary wave component from the DC pulsed signal, and outputs a pulse component to an anti-parallel diode pair 5. A band pass filter (referred to as a BPF from here on) 4 receives a local oscillation signal LO applied to a local oscillation wave input terminal 3, removes an unnecessary wave component from the local oscillation signal LO, and outputs the local oscillation signal from which the unnecessary wave component is removed to the anti-parallel diode pair 5.

The anti-parallel diode pair 5 includes two diodes 5a and 5b which are connected in parallel with and opposite in direction to each other, and constitutes a mixing means for mixing the local oscillation signal LO from which the unnecessary wave component is removed by the BPF 4, and the DC pulsed signal from which the unnecessary wave component is removed by the LPF 2, so as to generate and output an RF pulsed signal (a pulsed signal) having a frequency twice (even times) the frequency of the local oscillation signal LO to a BPF 6.

The BPF 6 allows only the RF pulsed signal delivered thereto from the anti-parallel diode pair 5 to pass therethrough, and outputs it to an RF pulse output terminal 7. A branching means is provided with the LPF 2 and BPFs 4 and 6.

A resistor 8 is disposed between the DC pulse applying terminal 1 and the LPF 2, and constitutes a voltage dividing means for dividing a voltage applied to the anti-parallel diode pair 5.

Next, the operation of the pulse modulation circuitry in accordance with this embodiment of the present invention will be explained.

First, a DC pulsed signal applied to the DC pulse applying terminal 1 is delivered to the LPF 2, and the LPF 2 removes an unnecessary wave component from the DC pulsed signal and outputs the pulse component of the DC pulsed signal to the anti-parallel diode pair 5.

A local oscillation signal LO applied to the local oscillation wave input terminal 3 is delivered to the BPF 4, and the BPF 4 removes an unnecessary wave component from the local oscillation signal LO and outputs it to the anti-parallel diode pair 5.

When the anti-parallel diode pair 5 receives the local oscillation signal LO from which the unnecessary wave component is removed by the BPF 4 and also receives the DC pulsed signal from which the unnecessary wave component is removed by the LPF2, the anti-parallel diode pair 5 mixes the local oscillation signal LO and DC pulsed signal to generate and furnish an RF pulsed signal having a frequency twice the frequency of the local oscillation signal LO to the BPF 6.

When receiving the RF pulsed signal from the anti-parallel diode pair 5, the BPF 6 allows only the RF pulsed signal to pass therethrough and outputs it to the RF pulse output terminal 7.

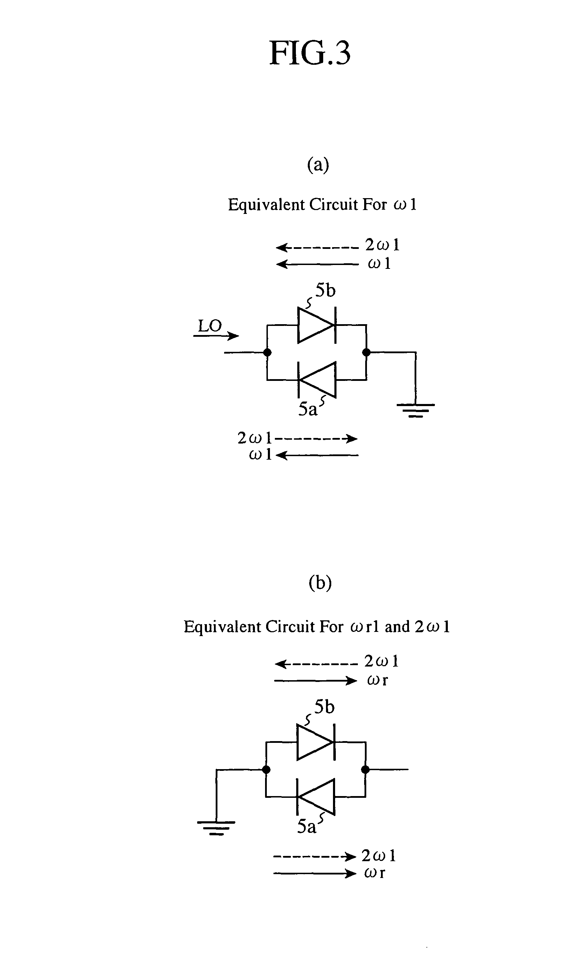

Hereafter, the operation of the anti-parallel diode pair 5 will be concretely explained. Fig. 3 shows the equivalent circuit of the anti-parallel diode pair 5.

For example, when a local oscillation signal LO of a frequency of ω1 is input to the local oscillation wave input terminal 3, for the local oscillation signal LO of a frequency of ω1, the grounded end of the anti-parallel diode pair 5 seems to be open-circuited, as shown in Fig. 3(a), and the other end of the anti-parallel diode pair 5 which is connected to the BPFs 4 and 6 seems to be short-circuited.

Therefore, noting that the diodes 5a and 5b of the pair are connected opposite in direction to each other, the component of a frequency of ω1 is applied to each of the diodes 5a and 5b such that the direction of the component applied to the diode 5a is opposite to that of the component applied to the diode 5b, and a component of a frequency of 2ω1 which is an eventh-order harmonic is applied to each of the diodes 5a and 5b such that the component of a frequency of 2ω1 applied to the diode 5a is in phase with the component of a frequency of 2ω1 applied to the diode 5b.

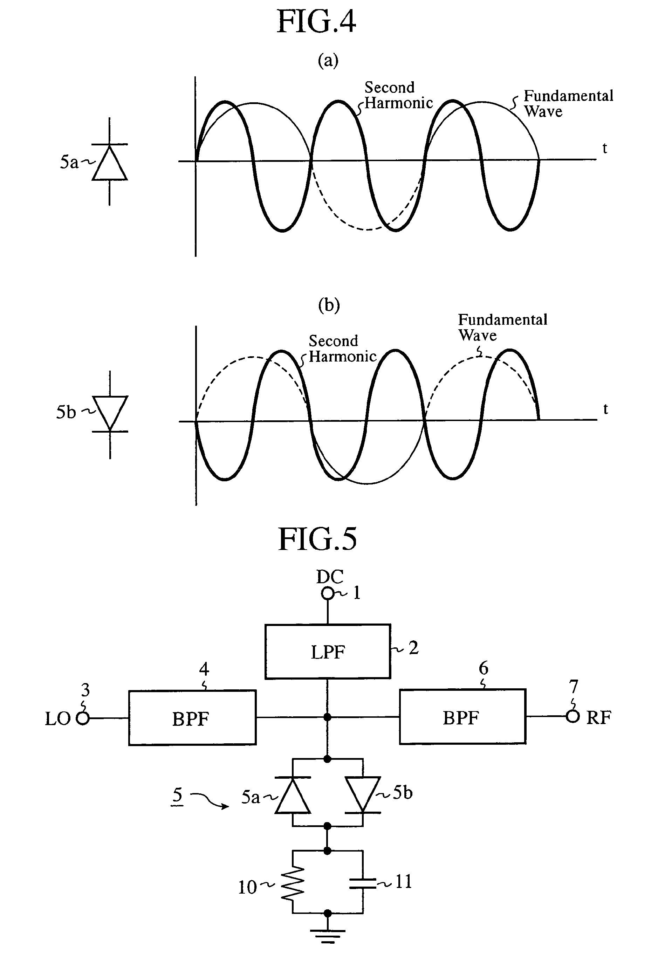

Fig. 4(a) shows the phase of the second harmonic of the signal which is half-wave rectified by the diode 5a, and Fig. 4(b) shows the phase of the second harmonic of the signal which is half-wave rectified by the diode 5b connected opposite in direction to the diode 5a.

As can be seen from the figures, the second harmonic outputted from the diode 5a is in opposite phase with the second harmonic outputted from the diode 5b.

On the other hand, for the local oscillation signal LO of a frequency of ωr which is about twice the frequency ω1, the grounded end of the anti-parallel diode pair 5 seems to be short-circuited, as shown in Fig. 3(b), and the other end of the anti-parallel diode pair 5 which is connected to the BPFs 4 and 6 seems to be open-circuited.

Therefore, since a component of a frequency (ωr-2ω1) which is the DC pulsed signal appears at each of the diodes 5a and 5b connected opposite in direction so that the component of a frequency (ωr-2ω1) applied to the diode 5a is in opposite phase with the component of a frequency (ωr-2ω1) applied to the diode 5b, they can be added and extracted from the diodes 5a and 5b.

Since the components of a frequency of 2ω1 generated by the diodes of the anti-parallel diode pair 5 are in opposite phase with each other at the RF pulse output terminal 7, no component of a frequency of 2ω1 leaks from the RF pulse output terminal 7.

Although it is understood from the above explanation that an RF pulsed signal having a frequency twice the frequency of the local oscillation signal, the RF pulsed signal being an oddth-order harmonic, is outputted from the RF pulse output terminal 7, since the resistor 8 is disposed between the DC pulse applying terminal 1 and the LPF 2, the voltage applied to the anti-parallel diode pair 5 can be set to an arbitrary voltage by properly adjusting the resistance of the resistor 8.

The horizontal axis of Fig. 2 shows the voltage of the DC pulsed signal (i.e., the voltage applied to the DC pulse applying terminal 1), and the vertical axis shows the output power of the RF pulsed signal. As the resistance of the resistor 8 is increased, the applied voltage which maximizes the output power of the RF pulsed signal is increased.

Therefore, when the resistance of the resistor 8 is increased in consideration of the fact that the influence of noise superimposed onto the applied voltage is large when the applied voltage is small, the ratio of the output power of the RF pulsed signal at the time of the ON state and the output power at the time of the OFF state can be increased.

Since neither the local oscillation signal LO nor the RF pulsed signal contributes to the resistor 8, the installation of the resistor 8 has no influence on the RF characteristics.

As can be seen from the above description, in the pulse modulation circuitry in accordance with this embodiment 1, the resistor 8 for dividing the voltage applied to the anti-parallel diode pair 5 which mixes the DC pulsed signal and local oscillation signal LO is disposed. Therefore, the present embodiment offers an advantage of being able to enlarge the ratio of the output power of the RF pulsed signal outputted to the RF pulse output terminal 7 at the time of the ON state and the output power at the time of the OFF state.

In a case where a variable resistor is used as the resistor 8, even when a driver circuit not shown changes properly the voltage of the DC pulsed signal applied to the DC pulse applying terminal 1 of the pulse modulation circuitry, the pulse modulation circuitry can adjust the voltage applied to the anti-parallel diode pair 5 properly according to the voltage of the DC pulsed signal.

### Embodiment 2.

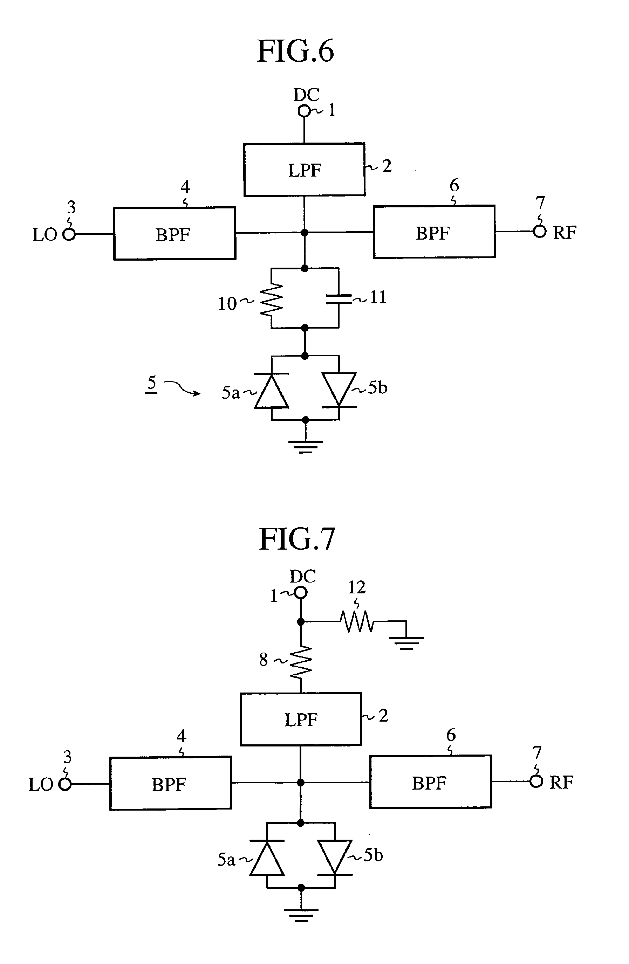

Fig. 5 is a block diagram showing pulse modulation circuitry in accordance with embodiment 2 of the present invention. In the figure, since the same reference numerals as shown in Fig. 1 denote the same components as those of embodiment 1 or like components, the explanation of the components will be omitted hereafter.

A parallel circuit including a resistor 10 and a capacitor 11 constitutes a voltage dividing means, and is installed between an anti-parallel diode pair 5 and a ground.

Next, the operation of the pulse modulation circuitry in accordance with this embodiment of the present invention will be explained.

The pulse modulation circuitry in accordance with above-mentioned embodiment 1 includes the resistor 8 for dividing the voltage applied to the anti-parallel diode pair 5, as previously mentioned. In contrast, in accordance with this embodiment, the resistor 10 of the parallel circuit can divide the voltage applied to the anti-parallel diode pair 5. Therefore, this embodiment can provide the same advantages as offered by above-mentioned embodiment 1.

Since both a local oscillation signal LO and an RF pulsed signal pass through the capacitor 11 and do not contribute to the resistor 10, the installation of the resistor 10 has no influence on the RF characteristics.

### Embodiment 3.

In accordance with above-mentioned embodiment 2, the parallel circuit which consists of the resistor 10 and capacitor 11 is disposed between the anti-parallel diode pair 5 and the ground, as previously mentioned. In contrast, in accordance with this embodiment, a parallel circuit which consists of a resistor 10 and a capacitor 11 is disposed between a connecting point at which BPFs 4 and 6 are connected to each other, and an anti-parallel diode pair 5, as shown in Fig. 6. Therefore, this embodiment can provide the same advantages as offered by above-mentioned embodiment 2.

### Embodiment 4.

Fig. 7 is a block diagram showing pulse modulation circuitry in accordance with embodiment 4 of the present invention. In the figure, since the same reference numerals as shown in Fig. 1 denote the same components as those of embodiment 1 or like components, the explanation of the components will be omitted hereafter.

A resistor 12 is disposed between a DC pulse applying terminal 1 and a ground, for suppressing an impedance mismatch for a DC pulsed signal applied to the DC pulse applying terminal. Next, the operation of the pulse modulation circuitry in accordance with this embodiment of the present invention will be explained.

In above-mentioned embodiment 1, the resistor 8 divides the voltage applied to the anti-parallel diode pair 5, as previously mentioned. When the DC pulsed signal has a narrow pulse width, it has a very-high-frequency component for a pulse wave.

Therefore, the method of dividing the voltage applied to the anti-parallel diode pair 5 using the resistor 8 can make the impedance from the DC pulse applying terminal 1 become very large, and can cause an impedance mismatch.

To solve this problem, in accordance with this embodiment 4, the resistor 12 is disposed between the DC pulse applying terminal 1 and the ground so as to suppress the impedance mismatch for the DC pulsed signal.

This embodiment 4 offers an advantage of being able to suppress the impedance mismatch over the DC pulsed signal in addition to the same advantages as provided by above-mentioned embodiment 1.

In this embodiment 4, the resistor 12 is additionally disposed in the pulse modulation circuitry of Fig. 1, as mentioned above. The resistor 12 can be additionally disposed in the pulse modulation circuitry of Fig. 5 or 6.

### Embodiment 5.

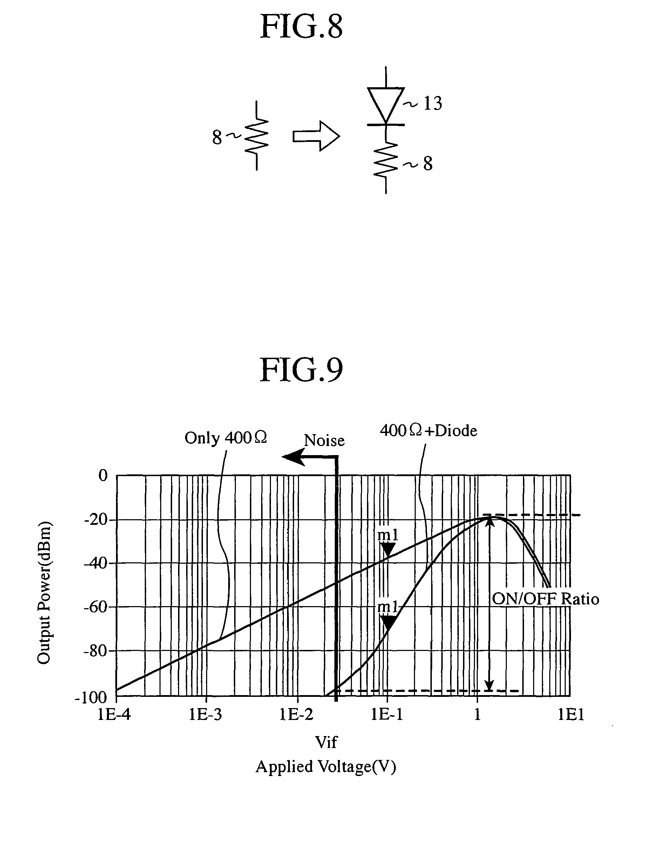

The pulse modulation circuitry in accordance with above-mentioned embodiment 1 includes the voltage dividing means which consists of the resistor 8, while the pulse modulation circuitry in accordance with above-mentioned embodiment 2 includes the voltage dividing means which consists of the parallel circuit including the resistor 10 and capacitor 11, as previously mentioned. In accordance with this embodiment, the voltage dividing means consists of a series circuit in which a diode 13 is connected in series with a resistor 8 (or 10), as shown in Fig. 8.

In the above-mentioned embodiment 1, as shown in Fig. 2, in order to raise the ratio of the output power of the RF pulsed signal at the time of the ON state, and the output power at the time of the OFF state, it is desirable to increase the resistance of the resistor at the time of the OFF state and to set the resistance of the resistor at the time of the ON state so that the output power of the RF pulsed signal can be maximized with a desired voltage being applied to the DC pulse applying terminal.

Therefore, in accordance with this embodiment 5, the diode 13 is connected in series with the resistor 8 (or 10).

Fig. 9 shows characteristics in the case the diode 13 is connected in series with the resistor 8 (or 10), and, in this case, the resistance of the series circuit placed in a state in which no voltage is applied to the DC pulse applying terminal 1, i.e., in the OFF state becomes equal to "the resistance of the resistor 8 (or 10)" + "the resistance of the diode 13 at the time of the OFF state", and has a very large value.

On the other hand, the resistance of the series circuit placed in a state in which a voltage is applied to the DC pulse applying terminal 1, i.e. , in the ON state becomes equal to "the resistance of the resistor 8 (or 10)" + "the resistance of the diode 13 at the time of the ON state". In this case, since the resistance of the diode 13 at the time of the ON state is typically of order of several ohms, the resistance of the series circuit has a value close to that of the resistor 8 (or 10).

Therefore, this embodiment offers an advantage of being able to further raise the ratio of the output power of the RF pulsed signal at the time of the ON state, and the output power at the time of the OFF state.

### Embodiment 6.

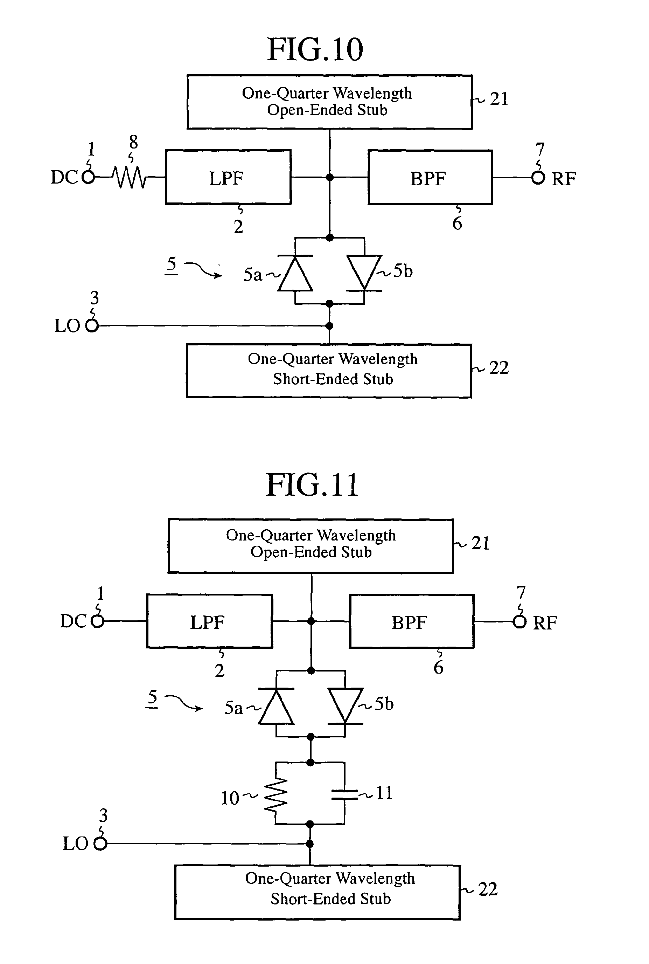

Fig. 10 is a block diagram showing pulse modulation circuitry in accordance with embodiment 6 of the present invention. In the figure, since the same reference numerals as shown in Fig. 1 denote the same components as those of embodiment 1 or like components, the explanation of the components will be omitted hereafter.

A one-quarter wavelength open-ended stub 21 has an electric length equal to the one-quarter wavelength of a local oscillation signal LO, and has an end which is open-circuited. A one-quarter wavelength short-ended stub 22 has an electric length equal to the one-quarter wavelength of the local oscillation signal LO, and has an end which is short-circuited. Next, the operation of the pulse modulation circuitry in accordance with this embodiment of the present invention will be explained.

In above-mentioned embodiment 1, the branching means consists of the LPF 2 and BPFs 4 and 6, as previously mentioned. In contrast, in the pulse modulation circuitry in accordance with this embodiment, the branching means consists of an LPF 2 and a BPF 6, and the one-quarter wavelength open-ended stub 21 and one-quarter wavelength short-ended stub 22 are disposed so that a local oscillation signal LO is input into the pulse modulation circuitry via a connecting point between an anti-parallel diode pair 5 and the one-quarter wavelength short-ended stub 22.

Also in this case, the anti-parallel diode pair 5 mixes the local oscillation signal LO and a DC pulsed signal so as to furnish an RF pulsed signal having a frequency twice that of the local oscillation signal LO to the BPF 6 based on the same principle as explained in above-mentioned embodiment 1.

Since a resistor 8 is disposed between a DC pulse applying terminal 1 and the LPF 2, a voltage applied to the anti-parallel diode pair 5 can be set to an arbitrary one by adjusting the resistance of the resistor 8 properly, as in the case of above-mentioned embodiment 1.

Therefore, the present embodiment offers an advantage of being able to enlarge the ratio of the output power of the RF pulsed signal outputted to an RF pulse output terminal 7 at the time of the ON state and the output power at the time of the OFF state, like above-mentioned embodiment 1.

In a case where a variable resistor is used as the resistor 8, even when a driver circuit not shown changes properly the voltage of the DC pulsed signal applied to the DC pulse applying terminal 1 of the pulse modulation circuitry, the pulse modulation circuitry can adjust the voltage applied to the anti-parallel diode pair 5 properly according to the voltage of the DC pulsed signal.

Also in the case of this embodiment 6, since neither the local oscillation signal LO nor the RF pulsed signal contributes to the resistor 8, the installation of the resistor 8 has no influence on the RF characteristics.

### Embodiment 7.

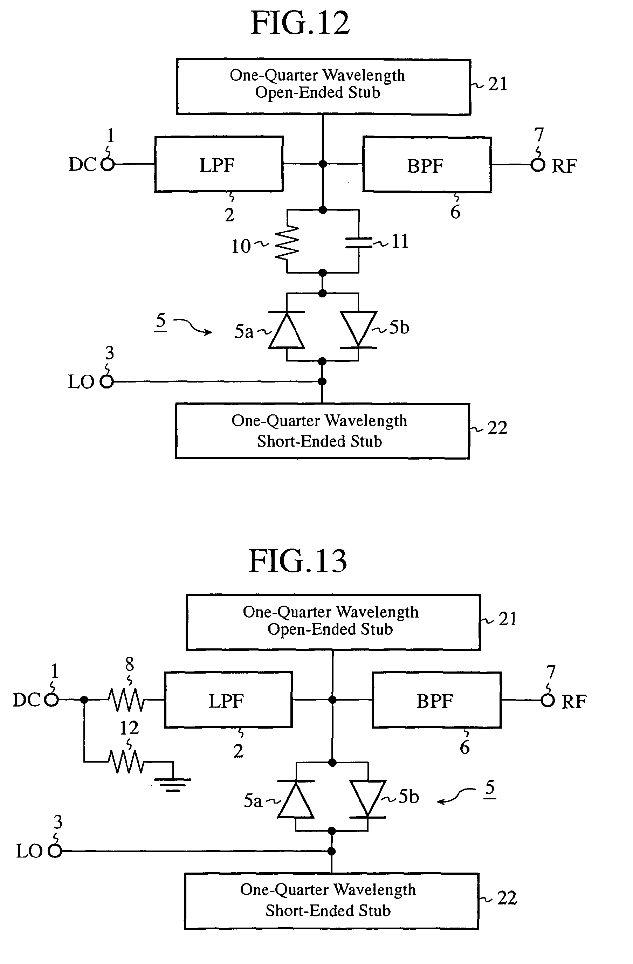

The pulse modulation circuitry in accordance with above-mentioned embodiment 6 includes the resistor 8 for dividing the voltage applied to the anti-parallel diode pair 5, as previously mentioned. In contrast, in accordance with this embodiment, a resistor 10 of a parallel circuit can divide the voltage applied to the anti-parallel diode pair 5, as shown in Fig. 11 or 12. This embodiment can provide the same advantages as offered by above-mentioned embodiment 6.

Since the local oscillation signal LO and RF pulsed signal pass through a capacitor 11 of the parallel circuit and do not contribute to the resistor 10, the installation of the resistor 10 has no influence on the RF characteristics.

### Embodiment 8.

In above-mentioned embodiment 6, the resistor 8 divides the voltage applied to the anti-parallel diode pair 5, as previously mentioned. When the DC pulsed signal has a narrow pulse width, it has a very-high-frequency component for a pulse wave.

Therefore, the method of dividing the voltage applied to the anti-parallel diode pair 5 using the resistor 8 can make the impedance from the DC pulse applying terminal 1 become very large, and can cause an impedance mismatch.

To solve this problem, in accordance with this embodiment 8, a resistor 12 is disposed between the DC pulse applying terminal 1 and the ground so as to suppress the impedance mismatch for the DC pulsed signal.

This embodiment 8 offers an advantage of being able to suppress the impedance mismatch for the DC pulsed signal in addition to the same advantages as provided by above-mentioned embodiment 6.

In this embodiment 6, the resistor 12 is additionally disposed in the pulse modulation circuitry of Fig. 10, as mentioned above. The resistor 12 can be additionally disposed in the pulse modulation circuit of Fig. 11 or 12.

### Embodiment 9.

In above-mentioned embodiments 6 to 8, the diode 13 is not connected in series with the resistor 8 (or 10), as previously mentioned. As an alternative, the diode 13 can be connected in series with the resistor 8 (or 10) of the pulse modulation circuitry of Fig. 10, 11, or 12, as in the case of above-mentioned embodiment 5.

Therefore, the present embodiment offers an advantage of being able to enlarge the ratio of the output power of the RF pulsed signal at the time of the ON state and the output power at the time of the OFF state, like above-mentioned embodiment 5.

### Industrial Applicability

As mentioned above, the pulse modulation circuitry in accordance with the present invention is suitable for a communications apparatus and a radar which need to modulate the frequency of a pulsed signal when, for example, transmitting or receiving the pulsed signal.

## Claims

1. Pulse modulation circuitry comprising: a branching mean for receiving a pulsed signal from a pulse applying terminal and also receiving a local oscillation signal from a local oscillation wave input terminal, and for outputting a pulsed signal having a frequency even times the frequency of the local oscillation signal to a pulse output terminal; a mixing means for mixing the pulsed signal delivered thereto by said branching means and the local oscillation signal, and for furnishing a pulsed signal having a frequency even times the frequency of the local oscillation signal to said branching means; and a voltage dividing means for dividing a voltage applied to said mixing means.

2. The pulse modulation circuitry according to Claim 1, **characterized in that** the voltage dividing means which consists of a resistor is disposed between the pulse applying terminal and the branching means.

3. The pulse modulation circuit according to Claim 2, **characterized in that** the resistor which constitutes the voltage dividing means is a variable resistor.

4. The pulse modulation circuitry according to Claim 1, **characterized in that** the voltage dividing means which consists of a parallel circuit including a resistor and a capacitor is disposed between the mixing means and a ground, or between the branching means and said mixing means.

5. The pulse modulation circuitry according to Claim 1, **characterized in that** a resistor is disposed between the pulse applying terminal and a ground.

6. The pulse modulation circuitry according to Claim 1, **characterized in that** the voltage dividing means which consists of a series circuit including a resistor and a diode is disposed between the pulse applying terminal and the branching means.

7. The pulse modulation circuitry according to Claim 1, **characterized in that** the voltage dividing means which consists of a parallel circuit in which a series circuit including a resistor and a diode and a capacitor are connected in parallel is disposed between the mixing means and a ground or between the branching means and said mixing means.

8. Pulse modulation circuitry comprising: a branching mean for receiving a pulsed signal from a pulse applying terminal, and for outputting a pulsed signal having a frequency even times a frequency of a local oscillation signal to a pulse output terminal; a mixing means for mixing the pulsed signal delivered thereto by said branching means and the local oscillation signal delivered thereto from a local oscillation wave input terminal, and for furnishing a pulsed signal having a frequency even times the frequency of the local oscillation signal to said branching means; and a voltage dividing means for dividing a voltage applied to said mixing means.

9. The pulse modulation circuit according to Claim 8, **characterized in that** the voltage dividing means which consists of a resistor is disposed between the pulse applying terminal and the branching means.

10. The pulse modulation circuit according to Claim 9, **characterized in that** the resistor which constitutes the voltage dividing means is a variable resistor.

11. The pulse modulation circuit according to Claim 8, **characterized in that** the voltage dividing means which consists of a parallel circuit including a resistor and a capacitor is disposed between the mixing means and the local oscillation wave input terminal, or between the branching means and said mixing means.

12. The pulse modulation circuit according to Claim 8, **characterized in that** a resistor is disposed between the pulse applying terminal and a ground.

13. The pulse modulation circuit according to Claim 8, **characterized in that** the voltage dividing means which consists of a series circuit including a resistor and a diode is disposed between the pulse applying terminal and the branching means.

14. The pulse modulation circuitry according to Claim 8, **characterized in that** the voltage dividing means which consists of a parallel circuit in which a series circuit including a resistor and a diode and a capacitor are connected in parallel is disposed between the mixing means and the local oscillation wave input terminal or between the branching means and said mixing means.
